(19) Europäisches Patentamt
European Patent Office
Office européen des brevets

(11) EP 3 054 590 B1

(12) **EUROPEAN PATENT SPECIFICATION**

(45) Date of publication and mention
of the grant of the patent:
**20.03.2019 Bulletin 2019/12**

(51) Int Cl.:
*H03F 1/32* *(2006.01)*

(21) Application number: **16150791.8**

(22) Date of filing: **16.11.2012**

(54) **SYSTEM LINEARIZATION**

SYSTEMLINEARISIERUNG

LINÉARISATION DE SYSTÈME

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.11.2011 US 201161560889 P**
**21.09.2012 US 201261703895 P**

(43) Date of publication of application:
**10.08.2016 Bulletin 2016/32**

(62) Document number(s) of the earlier application(s) in
accordance with Art. 76 EPC:
**12798973.9 / 2 781 018**

(73) Proprietor: **Analog Devices, Inc.**
**Norwood, MA 02062-9106 (US)**

(72) Inventors:
• **WEBER, Theophane**
**Cambridge, MA Massachusetts 02138 (US)**
• **VIGODA, Benjamin**
**Winchester, MA Massachusetts 01890 (US)**

• **PRATT, Patrick**
**County Cork (IE)**
• **PARK, Joshua**
**Billerica, MA Massachusetts 01821 (US)**

(74) Representative: **Horler, Philip John et al**
**Withers & Rogers LLP**
**4 More London Riverside**
**London SE1 2AU (GB)**

(56) References cited:
**EP-A1- 1 998 436       EP-A2- 1 983 659**
**WO-A1-01/08297        US-A1- 2004 247 042**
**US-A1- 2005 195 919   US-A1- 2005 212 596**
**US-A1- 2005 242 876**

• **JIE PENG ET AL: "Partial Correlation Estimation
by Joint Sparse Regression Models", JOURNAL
OF THE AMERICAN STATISTICAL
ASSOCIATION, vol. 104, no. 486, 2 June 2009
(2009-06-02), pages 735-746, XP055050340, ISSN:
0162-1459, DOI: 10.1198/jasa.2009.0126**

EP 3 054 590 B1

**Description**

<u>Cross-Reference to Related Applications</u>

This application claims the benefit of U.S. Provisional Application No. 61/560,889 filed November 17, 2011, and to U.S. Provisional Application No. 61/703,895 filed September 21, 2012.

<u>Background</u>

This invention relates to linearization of a system that includes a non-linear element, in particular to linearization of a electronic circuit having a power amplifier that exhibits non-linear input/output characteristics.

Many systems include components which are inherently non-linear. Such components include but are not limited to motors, power amplifiers, diodes, transistors, vacuum tubes, etc.

In general, a power amplifier has an associated operating range over a portion of which the power amplifier operates substantially linearly and over a different portion of which the power amplifier operates non-linearly. In some examples, systems including power amplifiers can be operated such that the power amplifier always operates within the linear portion of its operation range. However, certain applications of power amplifiers, such as in cellular base stations may use power amplifiers to transmit data according to transmission formats such as wideband code division multiple access (WCDMA) and orthogonal frequency division multiplexing (OFDM). Use of these transmission formats may result in signals with a high dynamic range. For such applications, transmitting data only in the linear range of the power amplifier can be inefficient. Thus, it is desirable to linearize the non-linear portion of the power amplifier's operating range such that data can safely be transmitted in that range.

One effect of non-linear characteristics in a radio frequency transmitter is that the non-linearity results in increase in energy outside the desired transmission frequency band, which can cause interference in adjacent bands.

European patent application EP 1998436 discloses a method and a device for at least partially compensating nonlinear effects of a system comprising the steps of (i) evaluating a model of the system, (ii) determining an inverse model of the system by processing an iterative inverting method, said inverting method comprising a convergence check, (iii) substantially compensating the nonlinear effects of the system by said inverse model of the system.

United States patent application US 2005/0242876 discloses a power amplifier predistortion method involving generating a reverse model of a power amplifier block. The reverse model is based on modeled output signal values of the power amplifier block and sampled output signal values of the power amplifier block.

United States patent application US 2005/195919 discloses a system for digitally linearizing the nonlinear behaviour of RF high efficiency amplifiers employing baseband predistortion techniques is disclosed. The system provides additive or multiplicative predistortion of the digital quadrature (I/Q) input signal in order to minimize distortion at the output of the amplifier. The predistorter uses a discrete-time polynomial kernel to model the inverse transfer characteristic of the amplifier, providing separate and simultaneous compensation for nonlinear static distortion, linear dynamic distortion and nonlinear dynamic effects including reactive electrical memory effects.

European patent application EP 1983659 discloses a Dynamic Digital Pre-Distortion (DDPD) system is disclosed to rapidly correct power amplifier (PA) non-linearity and memory effects. To perform pre-distortion, a DDPD engine predistorts an input signal in order to cancel PA nonlinearities as the signal is amplified by the PA. The DDPD engine is implemented as a composite of one linear filter and N-1 high order term linear filters. The bank of linear filters have programmable complex coefficients. To compute the coefficients, samples from the transmit path and a feedback path are captured, and covariance matrices A and B are computed using optimized hardware. After the covariance matrices are computed, Gaussian elimination processing may be employed to compute the coefficients.

United States patent application US 2004/247042 discloses a solution is disclosed for achieving a functional complex base-band adaptive digital nonlinear device model providing RF-power amplifier distortion (i.e. linearization or pre-distortion) minimizing distortion characterization including memory effects. The solution is based on real device non-linear performance observations and the physical cause for the distortion is compensated in the application. This also means that a pre-distorter digital circuit is denved to have the inverse functionality of the digital device model. The model and the digital pre-distortion circuit are designed in such way, that function blocks are connected in cascade. Each function block is then designed to handle a certain type of distortion performance and can be optimized individually. The model gives possibilities to describe and evaluate different device properties.

International patent application WO 01/08297 discloses a predistortion system comprises a digital compensation signal processing component which predistorts a wideband input transmission signal to compensate for the frequency and time dependent AM-AM and AM-PM distortion characteristics of a non-linear amplifier. The DCSP comprises data structure in which each element stores a set of compensation parameters (preferably including FIR filter coefficients) for predistorting the input transmission signal. The parameter sets are preferably indexed within the data structure according to multiple signal characteristics, such as instantaneous amplitude and integrated signal envelope, each of which corresponds to a respective dimension of the data structure. The sets of compensation parameters are generated periodically and written to the data structure by an adaptive control processing and compensation estimator (ACPCE) that performs a non-real-time analysis of amplifier input and output signals. The ACPCE also implements various system identification processes for measuring the characteristics of the power amplifier and generating initial sets of filter coefficients.

United States patent application US 2004/247042 discloses a method of processing a signal. The method comprises generating a digital signal, converting the digital signal to an analog signal, and generating an amplified analog signal having distortions. The method further comprises converting the amplified analog signal to a feedback digital signal at a sample rate and updating a model of the distortions based on the feedback digital signal.

Academic paper authored by Jie Peng et al titled "Partial Correlation Estimation by Joint Sparse Regression Models" discloses an approach-space (Sparse PArtial Correlation Estimation)-for selecting nonzero partial correlations under the high-dimension-low-sample-size setting. This method assumes the overall sparsity of the partial correlation matrix and employs sparse regression techniques for model fitting. This method illustrates the performance of space by simulation studies. This method is then applied to a microarray breast cancer dataset and identify a set of hub genes that may provide important insights on genetic regulatory networks. Finally, under a set of suitable assumptions, the proposed procedure is asymptotically consistent in terms of model selection and parameter estimation. US2005/212596 discloses a linearisation system for a non-linear element, comprising a forward-model based predistorter whose model is adapted based on inputs and outputs of the non-linear elements

Summary

A first aspect provides a method for generating an input signal for a non-linear device, according to claim 1.

A second aspect provides a system for linearizing a non-linear element, according to claim 12.

A third aspect provides a non-transitory computer readable medium according to claim 17.

In one example, in general, a method for linearizing a non-linear system element includes acquiring data representing inputs and corresponding outputs of the non-linear system element. A model parameter estimation procedure is applied to the acquired data to determine model parameters of a model characterizing input-output characteristics of the non-linear element. An input signal representing a desired output signal of the non-linear element is accepted and processed to form a modified input signal according to the determined model parameters. The processing includes, for each of a series of successive samples of the input signal applying an iterative procedure to determining a sample of the modified input signal according to a predicted output of the model of the non-linear element. The modified input signal is provided for application to the input of the non-linear element.

Examples can include one or more of the following features.

The non-linear system element comprises a power amplifier, for example, a radio frequency power or an audio frequency power amplifier.

Applying the model parameter estimation procedure comprises applying a sparse regression approach, including selecting a subset of available model parameters for characterizing input-output characteristics of the model.

Applying the iterative procedure comprises applying a numerical procedure to solve a polynomial equation or applying a belief propagation procedure

Applying the iterative procedure to determining a sample of the modified input signal according to a predicted output of the model of the non-linear element comprises first determining a magnitude of the sample and then a phase of said sample.

The model characterizing input-output characteristics of the non-linear element comprises a memory polynomial.

The model characterizing input-output characteristics of the non-linear element comprises a Volterra series model.

The model characterizing input-output characteristics of the non-linear element comprises a model that predicts an output of the non-linear element based data representing a set of past inputs and a set of past outputs of the element. In some examples, the model characterizing input-output characteristics of the non-linear element comprises an Infinite Impulse Response (IIR) model.

Acquiring data representing inputs and corresponding outputs of the non-linear system element comprises acquiring non-consecutive outputs of the non-linear element, and the model parameter estimation procedure does not require consecutive samples of the output.

In another example, in general, software stored on a machine-readable medium comprises instructions to perform all the steps of any of the processes described above.

In another example, in general, a system is configured to perform all the steps of any of the processes described above.

Examples can include the following advantages.

By estimating parameters of a model of the non-linear system element (i.e., a forward model from input to output) rather than parameters that directly represent a predistorter (e.g., an inverse model), a more accurate linearization may be achieved for a given complexity of model.

Performing the iterative procedure for each sample provides accurate linearization and in many implementations, requires relatively few iterations per sample.

Other features and advantages of the invention are apparent from the following description, and from the claims.

Description of Drawings

FIG. 1 is a first power amplifier linearization system.

FIG. 2 is a second power amplifier linearization system.

FIG. 3 is a factor graph for determining a pre-distorted input to a power amplifier.

Description

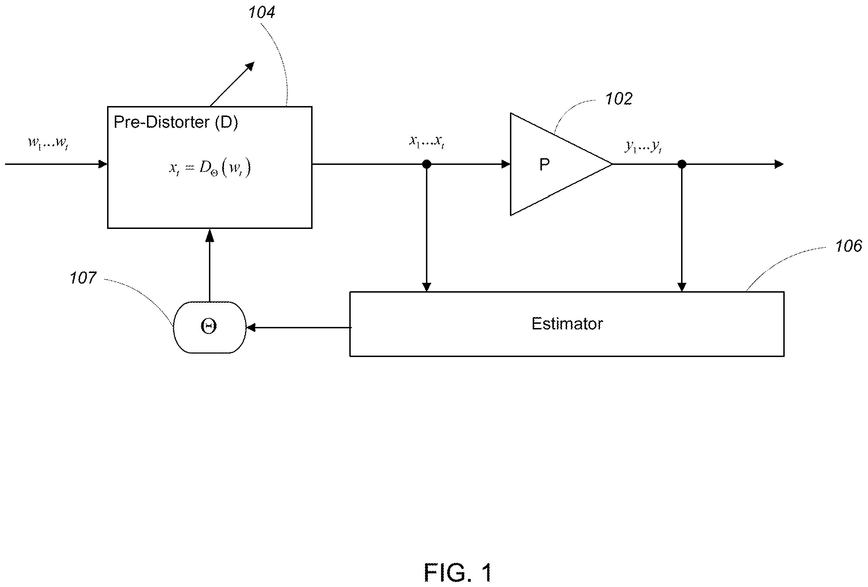

Referring to FIG. 1, one or more approaches described below are directed to a problem of compensating for non-linearities in a system component. The approaches are described initially in the context to linearizing a power amplifier, but it should be understood that this is only one of a number of possible contexts for the approach.

In FIG. 1, a non-linear element $P$ 102, for example, a power amplifier, accepts a discrete time series time series $x_1,...,x_t$ and outputs a time series $y_1,...,y_t = P(x_1,...,x_t)$. If $P$ 102 were ideal and linear, and assuming it has unit gain, then $y_i = x_i$ for all $i$. The element 102 is not ideal, for example, because the element 102 introduces a memoryless nonlinearity, and more generally, because the non-linearity of the element has memory, for example, representing electrical state of the element.

It should be understood that in the discussion below, the input and outputs of the non-linear element are described as discrete time signals. However, these discrete time values are equivalently samples of a continuous (analog) waveform, for example, sampled at or above the Nyquist sampling rate for the bandwidth of the signal. Also, case of a radio frequency amplifier, in some examples, the input and output values are baseband signals, and the non-linear element includes the modulation to a transmission radio frequency and demodulation back to the baseband frequency. In some examples, the inputs represent an intermediate frequency signal that represents a frequency multiplexing of multiple channels. Furthermore, in general, the inputs and output are complex values, representing modulation of the quadrature components of the modulation signal.

Referring to FIG. 1, one approach to compensating for the non-linearity is to cascade a predistortion element (predistorter) $D$ 104, often referred to as a Digital Pre-Distorter (DPD), prior to the non-linear element 102 such that a desired output sequence $w_1,...,w_t$ is passed through $D$ 104 to produce $x_1,...,x_t$ such that the resulting output $y_1,...,y_t$ matches the desired output to the greatest extent possible. In some examples, as illustrated in FIG. 1, the predistorter is memoryless such that the output $x_t$ of the predistorter is a function of the desired output value $w_t$, such that $x_t = D_\Theta(w_t)$ for some parameterized predistortion function $D_\Theta(\ )$.

As introduced above, in some examples, the predistortion function is parameterized by a set of parameters $\Theta$ 107. These parameters can be tracked (e.g., using a recursive approach) or optimized (e.g., in a batch parameter estimation), for example by using an estimator 106, to best match the characteristics of the actual non-linear element $P$ 102 to serve as a pre-inverse of its characteristics. In some examples, the non-linear element $P$ has a generally sigmoidal input-output characteristic such that at high input amplitudes, the output is compressed. In some examples, the parameters $\Theta$ characterize the shape of the inverse of that sigmoidal function such that the cascade of $D$ 104 and $P$ 102 provides as close to an identity (or linear) transformation of the desired output $w_t$.

Note that in general, a predistorter of the type shown in FIG. 1 is not necessarily assumed to be memoryless. For example, $x_t$ can, in addition to $w_t$ depend on a window of length $T$ of past inputs $x_{t-T},...,x_{t-1}$ to the non-linear element, and if available, may also depend on measured outputs $y_{t-T},...,y_{t-1}$ of the nonlinear element itself. The functional forms of $D$ 104 that have been used including memory polynomials, Volterra series, etc., and various approaches to estimating the parameters $\Theta$ 107, for example, using batch and/or adaptive approaches have been used.

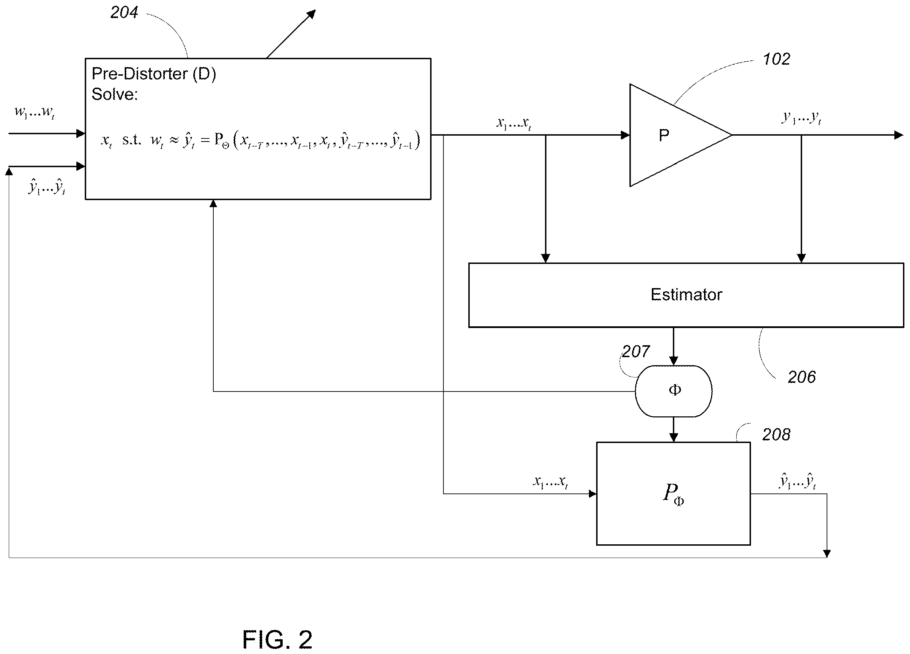

Referring to FIG. 2, an alternative approach makes use of a different architecture than that shown in FIG. 1. In the architecture shown in FIG. 2, a predistorter $D$ 204 is used in tandem with the nonlinear element 102. Operation of the predistorter is controlled by a set of estimated parameters $\Theta$. However, rather than parameterizing the predistorter $D$ directly with a set of parameters $\Theta$ to serve as a suitable pre-inverse as in FIG. 1, operation of the predistorter is controlled by a set of parameters $\Phi$ that characterize the non-linear element $P$ 102 itself. In particular, a model $P_\Phi$ 208 is parameterized by $\Phi$ to best match the characteristics of the true non-linear element $P$ 102.

As is more fully discussed below, the parameters $\Phi$ are determined from a past paired samples $(x_1, y_1),...,(x_\tau, y_\tau)$ observed that the inputs and outputs of the true non-linear element. As with possible direct parameterizations of a predistorter, a variety of parameterizations of $P_\Phi$ 208 may be used, as is discussed further later in this description.

In general, the model $P_\Phi$ 208 provides a predicted output $\hat{y}_t$ from a finite history of past inputs up to the current time $x_{t-T},...,x_t$ as well as a finite history up to the previous time of predicted outputs $\hat{y}_{t-T},...,\hat{y}_{t-1}$. Very generally, operation of the predistorter $D$ 204 involves, for each new desired output $w_t$, finding the best $x_t$ such that $w_t = P_\Phi(x_{t-T},...,x_t,\hat{y}_{t-T},...,\hat{y}_{t-1})$ exactly, or that minimizes a distortion $\|w_t - P_\Phi(x_{t-T},...,x_t,\hat{y}_{t-T},...,\hat{y}_{t-1})\|$.

Operation of the architecture shown in FIG. 2 depends on characteristics of the system including:

a. The functional form of the model $P_\Phi$ 208;

b. The procedure used by the predistorter to determine successive values of $x_t$ such that the model outputs $\hat{y}_t$ match the desired outputs $w_t$; and

c. The procedure used to estimate the model parameters $\Phi$ using the estimator 206.

Turning first to the functional form of the nonlinearity model, choices include Volterra series, memory polynomials (optionally generalized with cross terms), and kernel function based approaches.

One specific example of a parametric form of $P_\Phi$ 208, we assume an $N^{th}$ order memory polynomial of the form

$$\hat{y}_t = P_\Phi(x_{t-T},...,x_t) = \sum_{j=0}^{T} \sum_{k=0}^{N} a_{j,k} \mid x_{t-j} \mid^k x_{t-j}$$

such that the parameters are $\Phi = (a_{j,k}; 0 \leq j \leq T, 0 \leq k \leq N)$.

In some examples, other forms of the model $P_\Phi$ may also be used. For example, a memory polynomial including cross terms may be used:

$$\hat{y}_t = \sum_{i=0}^{T}\sum_{j=0}^{T} \sum_{k=0}^{N} a_{i,j,k} \mid x_{t-j} \mid^k x_{t-i}.$$

Yet other forms can be used, including an internal feedback ("infinite impulse response", "IIR") form, such as

$$\hat{y}_t = x_t - \sum_{i=1}^{T}\sum_{j=1}^{T} \sum_{k=0}^{N} a_{i,j,k} \mid \hat{y}_{t-j} \mid^k \hat{y}_{t-i}.$$

Yet other forms make use of physically motivated models in which hidden state variables (e.g., temperature, charge, etc.) are included and explicitly accounted for in a factor graph.

Turning now to implementation of the predistorter, in some examples, each time output involves solution of a polynomial equation. The parameterization of $P_\Phi$ 208 is decomposable into a term that depends on $x_t$, and a term that only depends on past values $x_{t-\tau}$ and past values $\hat{y}_{t-\tau}$:

$$w_t = F_\Phi(x_t,...) + G_\Phi(x_{t-T},...,x_{t-1}, \hat{y}_{t-T},...,\hat{y}_{t-1}).$$

At a particular time step t, the term $G_\Phi$ is treated as a constant g , which depends both on the parameters $\Phi$, and in general on past values $x_{t-\tau}$ and/or past values $\hat{y}_{t-\tau}$ and the term $F_\Phi$ is a function $f(x_t)$ of the one unknown complex variable $x_t$, where the particular function $f$ depends both on the parameters $\Phi$, and in general (e.g., in a memory polynomial with cross terms) on past values $x_{t-\tau}$ and past values $\hat{y}_{t-\tau}$ (e.g., in an IIR memory polynomial form). Therefore, the goal at that time step is to find a $x_t$ such that $f(x_t) = w_t + g$.

Taking an example of a memory polynomial, $f(x)$ has the function form $f(x) = b_0 x + \sum_{k \geq 1} b_k |x|^k x$. Note that $x$ is complex, so that $f(x)$ is not strictly a polynomial function and therefore convention methods for finding roots of a polynomial are not directly applicable to find $x_t$. One approach to solving $f(x) = z$ is to apply Picard's method, which comprises an iteration beginning at an initial estimate $x^{(0)}$, for example $x^{(0)} = z$ and iterating over $k$:

$$x^{(k+1)} = \frac{1}{b_0}\left( \tilde{y} - (f(x^{(k)}) - b_0 x^{(k)}) \right) .$$

In this approach, assuming that the parameters $\Phi$ are known, predistortion approach is as follows:

For $t = 0, 1, \ldots$.

Determine parameters $b_k$ for $f(\ )$ and fixed term g based on parameters $\Phi$, and (in general) on past values $x_{t-\tau}$ and past values $\hat{y}_{t-\tau}$;

Initialize $x^{(0)} = w_t - g$;

For $k = 1, 2, \ldots, K$

$$x^{(k+1)} = \frac{1}{b_0}\left( y - (f(x^{(k)}) - b_0 x^{(k)}) \right);$$

Set $x_t = x^{(K)}$;

Predict $\hat{y}_t$ based on $\Phi$ and new $x_t$;

Other approaches than Picard's method may be used to solve for the best $x_t$ that matches the model output $\hat{y}_t$ with the desired output $w_t$ can be used. For example, a two-dimensional Newton Raphson approach may be used in which the argument of $f$ is treated as a two dimensional vector of the real and imaginary parts of $x$, and the value of $f$ is similarly treated as a two-dimensional vector. Yet another approach is to represent the argument and value of $f$ in polar form (i.e., as a magnitude and a complex angle), and solve for the magnitude using a one-dimensional Newton Ralphon approach, and then solving for the angle after the magnitude is known.

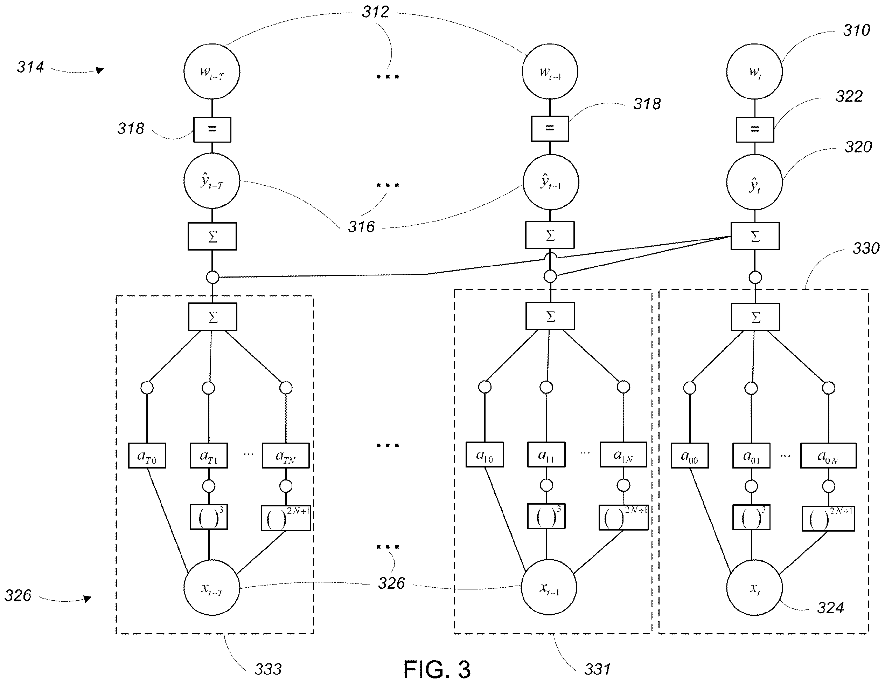

Referring to FIG. 3, another approach to determining $x_t$ at each time step is to use a factor graph 300, which is illustrated for the case of a memory polynomial without cross terms. In this case, the model takes the form

$$w_t = F_\Phi(x_t) + G_\Phi(x_{t-T}, \ldots, x_{t-1}, \hat{y}_{t-T}, \ldots, \hat{y}_{t-1})$$

where $F_\Phi$ does not depend on past values $x_{t-\tau}$ or $y_{t-\tau}$, taking the form

$$F_\Phi(x_t) = \sum_{k=0}^{N} a_{0,k} |x_t|^k x_t .$$

One interpretation of the function of the factor graph is to implicitly compute the inverse

$$x_t = F_\Phi^{-1}\left( w_t - G_\Phi(x_{t-T}, \ldots, x_{t-1}, \hat{y}_{t-T}, \ldots, \hat{y}_{t-1}) \right).$$

Referring to FIG. 3, the factor graph 300 representing the $N^{th}$ order memory polynomial described above can be implemented by the predistorter 204 of FIG. 2. In the factor graph 300, the current desired output value, $w_t$ 310 and a number of past desired output values, $w_{t-1} \ldots w_{t-T}$ 312 are known and illustrated in a top row 314 of variable nodes. Each variable node associated with a past desired output value, $w_{t-1} \ldots w_{t-T}$ 312 is coupled to a corresponding past estimated output variable, $y_{t-1} \ldots y_{t-T}$ 316 through an equal node 318. The current desired output variable, $w_t$ 310 is coupled to the predicted output $\hat{y}_t$ 320 through an equal node 322.

A pre-distorted input value, $x_t$ 324 and a number of past pre-distorted input values, $x_{t-1} \ldots x_{t-T}$ 326 are illustrated in the bottom row 328 of variable nodes. The past pre-distorted input values 326 are known and the current pre-distorted input value 324 is the value that is computed and output as the result of the factor graph 300.

In the current example, the factor graph 300 can be seen as including a number of sections 330, 331, ..., 333, each related to the desired inputs and predicted outputs at a given time step. In this example, each section 330, 331, ..., 333 includes a number of function nodes and variable nodes for calculating

$$a_{j,k} |x_{t-j}|^k x_{t-j}$$

for a single value of $j$ and all values of $k = 0...N$ (where $N = 2$ in the current example).

For example, the first section 330 calculates the value of the memory polynomial for $j = 0$ and $k = 0...N$ as:

$$\sum_{k=0}^{N} a_{0,k} \mid x_t \mid^k x_t,$$

the second section 331 calculates the value of the memory polynomial for $j = 1$ and $k = 0...N$ as:

$$\sum_{k=0}^{N} a_{1,k} \mid x_{t-1} \mid^k x_{t-1},$$

and so on.

The sections 330, 331,...,333 are interconnected such that the result of each section is summed, resulting in a factor graph implementation of the memory polynomial:

$$\hat{y}_t = \sum_{j=0}^{T} \sum_{k=0}^{N} a_{j,k} \mid x_{t-j} \mid^k x_{t-j}$$

Note one of the portions (i.e., portion 330) of the factor graph 300 effectively represents $F_\Phi$ identified above. In particular, the portion 330 of the factor graph 300 implements

$$F_\Phi(x_t) = \sum_{k=0}^{T} a_{0,k} \mid x_t \mid^k x_t$$

This section 330 has a functional from which remains fixed as long as the parameters, $\Phi$, remain fixed. In some examples, this fixed section 330 of the factor graph 300 is replaced with a lookup table which is updated each time the parameters are updated.

The remaining sections (331,..., 333) of the factor graph 300 implement

$$G_\Phi(\ ) = \sum_{j=1}^{T} \sum_{k=0}^{N} a_{j,k} \mid x_{t-j} \mid^k x_{t-j}$$

In operation, to calculate the output value, $x_t$ 324, messages are passed between nodes in the graph, where each message represents a summary of the information known by that node through its connections to other nodes. Eventually, the factor graph converges to a value of $x_t$. The resulting value of $x_t$ is a pre-distorted value which, when passed to the non-linear element (e.g., FIG. 2, element 204), causes the non-linear element to output a value $\hat{y}_t$ which closely matches the desired value $w_t$.

Note that the factor graph shown in FIG. 3 is one example, which is relatively simple. Other forms of factor graph may include different model structures. Furthermore, parameters of the model, shown in FIG. 3 as parameters (e.g., $a_{i,j}$) of function nodes may themselves be variables in a graph, for example, in a Bayesian framework. For example, such parameters variable may link a portion of a factor graph that constrains (estimates) the parameters based on past observations of ($x_t$, $y_t$) pairs.

Turning now to aspects related to estimation of parameters $\Phi$, we note that although the predistorter functions at the time scale of the signal variations that are passed through the non-linear element, estimation may be performed at a slower timescale, for example, updating the parameters relatively infrequently and/or with a time delay that is substantial compared to the sample time for the signal.

In some examples, the power amplifier linearization systems described above include two subsystems. The first subsystem implements a slower adaptation algorithm which takes blocks of driving values, $x_t,...,x_{t+\tau}$ and $y_t,...,y_{t+\tau}$

as inputs and uses them to estimate an updated set of parameters, Φ. The updated set of parameters are used to configure a predistorter (e.g., FIG. 2, element 204) which operates in a faster transmit subsystem. One reason for using such a configuration is that estimating the updated parameters can be a computationally intensive and time consuming task which can not feasibly be accomplished in the transmit path. Updating the parameters at a slower rate allows for the transmit path to operate at a high rate while still having an updated set of parameters for the predistorter.

Various approaches to estimating Φ may be used. In some examples, sparse sampling and/or cross validation techniques may be used. In some examples, the number of number of non-zero parameter values can be limited such that overfitting of the memory polynomial does not occur. In some examples, the parameters are adapted using algorithms such as LMS or RLS.

It is noteworthy that although the input-output characteristic of the model is non-linear, the dependency of the model on its parameters may be linear. For example, in the case of a memory polynomial, the output can be represented as

$$ y_t = \Phi^T \phi(t), $$

where

$$ \phi(t) = [\sum_{k=0}^{N} |x_{t-j}|^k \, x_{t-i} : i = 0,....,I; j = 0,...,J; k = 0,...,K]^T $$

and *I* is the number of taps, *J* is the number of cross terms, and *K* is the polynomial order. One approach is to use a set of ($y_t, \phi(t)$) pairs to determine a minimum mean squared estimate Φ by choosing $\Phi = (\phi^T\phi)^{-1}\phi^T y$ where $\phi$ is the matrix formed by $\phi(t)$.

In some examples, the estimate is performed periodically in a batch process, for example, collecting data for a time interval, computing Φ, and then operating the predistorter with those parameters. While operating with one set (vector) of parameters, in parallel new data may be collected for computing updated parameters.

Several aspects of the parameter estimation process are significant, including:

a. Avoiding overfitting the model

b. Avoiding extrapolation errors

c. Time sampling approaches for collecting the data from which the model parameters are obtained

One approach to avoid over-fitting is to assign a regularization prior on the coefficients theta. A regularizing prior could for instance be a Gaussian prior with standard deviation σ, which corresponds in the regression over Φ to an additional *L2* cost $(\sum \Phi_i^2)$ with multiplicative coefficient $1/\sigma^2$. For instance, this means that, in a linear regression,

$$ \sum_t |\text{actual\_output}(t) - \text{predicted\_output}(t,\theta)|^2, $$

instead of minimizing we minimize

$$ \sum_t |\text{actual\_output}(t) - \text{predicted\_output}(t,\theta)|^2 + (1/\sigma^2)\sum_i |\phi_i|^2). $$

In order to determine the optimal σ, one can compute the regression for a family of σ's, and use cross-validation to determine which sigma corresponded to the best generalization error (error computed on data not used in the training set).

It should be evident that there are potentially a great many parameters in the parameter set (vector) Φ. One approach to avoiding over-fitting makes use of sparse regression approaches. Generally, in such sparse regression approaches, only a limited number of elements of Φ are permitted to be non-zero. Examples of sparse regression approaches that are well known include matching pursuit, orthogonal matching pursuit, lasso, and cosamp. A benefit of sparse regression is also that the resulting predistortion has lower power and a reduced adaptation time. Another technique for sparse regression is to assign an additional sparsifying prior (such as an $L_1$ prior, $\sum_i |\phi_i|$ to the parameter set Φ. This prior can be combined with a regularizing prior as discussed above.

The inversion necessary for the calculation of $\Theta$ may be poorly conditioned. While regularization may help, a more effective solution is to use a linear combination of orthogonal polynomials instead of a linear combination of monomials. Here $\sum_{k=0}^{N} a_{j,k} \mid x_{t-j} \mid^{k}$ is replaced with a linear combination of orthogonal polynomials (e.g., Laguerre polynomials, Hermite polynomials, Chebyshev polynomials, etc...). This improves the conditioning of a minimum mean squared solution for RLS, and improves the convergence rate of algorithms such as LMS.

Another approach to regression makes use of frequency weighting, whose aim is to increase the quality of the model. In this approach, filter each component of the feature vector $\phi_t$, and filter the output vector $y_t$, and do the regression on those filtered components instead. The effect of doing so is that if the filter is weighted towards particular frequency bands, the model quality will increase on those corresponding bands. Note that this is not the same as traditional data filtering - we are not filtering data so that it has a particular frequency response; we are filtering the data that goes into the regression model so that the model decreases its error in particular frequency bands, for example, in sidelobe frequency bands.

In order to comply with wireless regulations, it is often necessary to reduce nonlinear distortion products in specific frequency bands (e.g., in adjacent channels) more than others. This can be accomplished by training the model to emphasize accuracy in these "critical bands". To incorporate frequency emphasis, a linear filter is designed (FIR or IIR) with a frequency response that amplifies the critical bands and attenuates the non-critical bands. The feature vectors in $\phi_t$ are passed through this filter to give a new weighted feature vector $\phi'_t$. The output $y_t$ is also passed through the same filter to give a weighted output $\setminus y'_t$. Regression proceeds on $\phi'_t$ and $y'_t$ instead of $\phi_t$ and $y_t$. The minimum mean squared solution is calculated $\Phi = (\phi'^{T}\phi')^{-1}\phi'^{T}y'$. This now minimizes the overall model prediction error but where error in the critical bands is weighted proportional to the amplification specified in the emphasis filter. It is understood that this weighting method applies to RLS and LMS as well.

In some cases, it may be difficult to compute $y'_t$ (e.g., if the output vector $\setminus y_t$ was sampled sparsely). To mitigate this, the calculation for $\Phi$ can be modified to include the filtering of $y$ in $\phi$ instead: $\Phi = (\phi'^{T}\phi')^{-1}\phi''^{T}y$. Where $\phi''(t)$ is the result of filtering $\phi(t)$ twice (i.e., filtering $\phi'(t)$ again). This corresponds exactly to the original weighted minimum mean squared solution but does not require filtering $y_t$.

Another issue that can arise due to repeated estimation of $\Phi$ is that even if the model does not overfit the data for the sampling window used for the estimation, the sampling window may not provide a sufficient richness of data over a range input conditions such that it the input characteristics change, the model may in fact extrapolate poorly, and potentially match worse than a simple linear model. An example of such a scenario can occur when the training data represents a relatively low power level, and the estimated model parameters match that low power operating condition well. However, if the power level increases, for example, to a degree that provokes non-linear characteristics, the model may essentially be extrapolating poorly.

One approach is to synthesize a training set for parameter estimation by merging data from a high-power situation, which may have been recorded in relatively old time interval, with actual samples in a relatively recent time interval. This combination yields good linearization in the operating condition in the recent time interval, as well as good linearization in an operating condition represented by the older high-power time interval. Furthermore, power levels in between are essentially interpolated, thereby improving over the extrapolation had the high-power data not been included.

Note that other approaches to synthesis of the training data sets may be used. For example, multiple older training intervals may be used to sample a range of operating conditions. In some examples, stored training data may be selected according to matches of operating conditions, such as temperature. Also, stored training data may be segregated by frequency (e.g., channel) in order to provide diversity in the training data across different frequencies even when the most recent training interval may represent data that is concentrated or limited to particular frequencies.

A third aspect relates to estimation of the model parameters. Recall that the estimation can be expressed as being based on a set of data pairs $(y_t, \phi(t))$ where $\phi(t)$ includes all the non-linear terms (i.e., including all the cross-terms) that are used in the model. A goal is to provide a mapping that is valid for all $t$ from $\phi(t)$ to $y_t$. However, it is not necessary to sample these data pairs at consecutive time samples, and more importantly one can sample $y_t$ in a sparse manner without affecting the quality of the regression. Note also that $\phi(t)$ does not depend on actual outputs $y_{t-\tau}$, but rather only on computed $x_{t-\tau}$ and/or $\hat{y}_{t-\tau}$. To construct $\phi(t1)$, $\phi(t2)$, .. $\phi(tn)$ for well separated times $t1$, $t2$ .. $tn$, we at most need to sample $y_{t1}, y_{t2}, y_{tn}$. Therefore although recording a vector $\phi(t)$ may involve successive samples of the computed quantities, the measured output $y_t$ is not required at successive time samples. Therefore, in some embodiments, the output of the non-linear element is downsampled (e.g., regularly downsampled at a fixed downsampling factor, or optionally irregularly), and corresponding vectors $\phi(t)$ at those times are also recorded, thereby enabling estimation based on the paired recorded data. In some examples, rather than recording $\phi(t)$ corresponding to the samples of the output $y_t$, the delayed

values $x_{t-\tau}$ and/or $\hat{y}_{t-\tau}$ are recorded. However, because of the form of the model, these quantities are required for successive time values. In some examples, some degree of subsampling is used for the input and model outputs, and interpolation is used to compute approximations of the terms needed for estimation of the parameters.

In a case where $\phi(t)$ does include 'bursts' of sampled $y_t$ at successive times, in order to construct $\phi(t)$, we would like to use several closely spaced $y$. One approach is to add to sparse sampling is to use a sparse-sampling compatible model to reconstruct the missing values $\hat{y}_t$. This can be called "model-based interpolation", since we are using a model of the PA, as well as related data $x$ or $w$, to properly interpolate and reconstruct the missing values y. Once those $y$ are reconstructed, we compute feature vectors $\phi$ and perform the desired regression.

Approaches described above can be implemented in software, in hardware, or a combination of software and hardware. Software can include instructions stored on a tangible computer readable medium for causing a processor to perform functions described above. The processor may be a digital signal processor, a general purpose processor, a numerical accelerator etc. Factor graph elements may be implemented in hardware, for instance in fixed implementations, or using a programmable "probability processing" hardware. The hardware can also include signal processing elements that have controllable elements, for example, using discrete-time analog signal processing elements.

It is to be understood that the foregoing description is intended to illustrate and not to limit the scope of the invention, which is defined by the scope of the appended claims. Other embodiments are within the scope of the following claims.

**Claims**

1. A method for linearizing a non-linear device (102), comprising:

    receiving data representing past predistorted inputs ($x_{t-T}...x_{t-1}$) of the non-linear device (102) and corresponding past outputs ($y_{t-T}...y_{t-1}$) of the non-linear device (102);
    applying a model parameter estimation procedure, using the received data to generate model parameters ($\Phi$) of a model (208) characterizing input-output characteristics of the non-linear device (102);
    receiving an input signal ($w_t$) representing a desired output signal of the non-linear device (102);
    generating a predistorted input signal ($x_t$) by, for each of a series of successive samples estimates of predistorted input signal ($x^{(k)}$), applying an iterative procedure to set the predistorted input signal ($x_t$) to a value that gives a predicted model output ($\hat{y}_t$) that best matches the desired output ($w_t$), based on the model parameters ($\Phi$), said past predistorted inputs ($x_{t-T}...x_{t-1}$) and corresponding past non-linear predicted model outputs ($\hat{y}_{t-T}...\hat{y}_{t-1}$); and
    providing the predistorted input signal ($x_t$) for application to the input of the non-linear device (102), to cause the non-linear device (102) to output a value ($y_t$) which closely matches the signal ($w_t$) representing the desired output signal.

2. The method of claim 1 wherein the non-linear device (102) comprises a power amplifier.

3. The method of claim 1 wherein applying the model parameter estimation procedure comprises applying a sparse regression approach, including selecting a subset of available model parameters for characterizing input-output characteristics of the model.

4. The method of claim 1 wherein applying the iterative procedure comprises applying a numerical procedure to solve a polynomial equation.

5. The method of claim 1 wherein applying the iterative procedure comprises applying a belief propagation procedure.

6. The method of claim 1 wherein applying the iterative procedure to generate the sample of the modified input signal comprises determining a magnitude of the sample and a phase of the sample.

7. The method of claim 1 wherein the model characterizing input-output characteristics of the non-linear device comprises a memory polynomial or a Volterra series model.

8. The method of claim 1 further comprising interpolating to find missing past outputs and using the interpolated past outputs in the model parameter estimation procedure.

9. The method of claim 1 wherein the model characterizing input-output characteristics of the non-linear device (102) comprises a model that predicts an output of the non-linear (102) device based data representing a set of past inputs and a set of past outputs of the device.

10. The method of claim 9 wherein the model characterizing input-output characteristics of the non-linear device (102) comprises an Infinite Impulse Response (IIR) model.

11. The method of any preceding claim, wherein the past outputs ($y_{t-T}...y_{t-1}$) of the non-linear device (102) are generated by irregular downsampling at a variable downsampling factor.

12. A system for linearizing a non-linear device (102), the system comprising:

an estimator (206) configured to receive data representing past samples of predistorted inputs ($x_{t-T}...x_{t-1}$) of the non-linear device (102) and corresponding past outputs ($y_{t-T}...y_{t-1}$) of the non-linear device (102) and apply a model parameter estimation procedure to generate model parameters ($\Phi$) of a model (208) characterizing input-output characteristics of the non-linear device (102), and the estimator (206) is configured to use the data representing the past samples of predistorted inputs ($x_{t-T}...x_{t-1}$) of the non-linear device (102) and corresponding past outputs ($y_{t-T}...y_{t-1}$) of the non-linear device (102) in the model parameter estimation procedure to generate the model parameters ($\Phi$); and
a predistorter (204) including:

an input configured to receive an input signal ($w_t$) representing a desired output signal of the non-linear device (102),
an input configured to receive the model parameters ($\Phi$) from the estimator (206),
an input configured to receive the predicted outputs ($\hat{y}_{t-T}...\hat{y}_{t-1}$) from the model (208),
a processing device configured to generate a predistorted input signal ($x_t$) by, for each of a series of successive samples of predistorted input signals, applying an iterative procedure to set the predistorted input signal ($x_t$) to a value that gives a predicted model output ($\hat{y}_t$) that best matches the desired output ($w_t$), based on the model parameters ($\Phi$), said past predistorted inputs ($x_{t-T}...x_{t-1}$) and corresponding past non-linear predicted model outputs ($\hat{y}_{t-T}...\hat{y}_{t-1}$), and
an output for providing the predistorted input signal (xt) for application to the input of the non-linear device in order to linearize an output of the non-linear device (102), to cause the non-linear device (102) to output a value ($y_t$) which closely matches the signal ($w_t$) representing the desired output signal.

13. The system of claim 12 wherein the estimator (206) is configured to apply a sparse regression approach that includes selecting a subset of available model parameters for characterizing input-output characteristics of the model (208).

14. The system of claim 12 wherein the processing device is configured to apply a numerical procedure to solve a polynomial equation or a belief propagation procedure.

15. The system of claim 12 wherein the model characterizing input-output characteristics of the non-linear device comprises a model that predicts an output of the non-linear device based on data representing a set of past inputs and a set of past outputs of the device.

16. The system of any one of claims 12 to 15, wherein the past outputs ($y_{t-T}...y_{t-1}$) of the non-linear device (102) are generated by irregular downsampling at a variable downsampling factor.

17. A non-transitory computer readable medium comprising instructions for causing a data processor to perform method steps defined in any of claims 1 to 11.


**Patentansprüche**

1. Verfahren zum Linearisieren einer nichtlinearen Vorrichtung (102), umfassend:

Empfangen von Daten, die frühere vorverzerrte Eingaben ($x_{t-T} ... x_{t-1}$) der nichtlinearen Vorrichtung (102) und entsprechende frühere Ausgaben ($y_{t-T} ... y_{t-1}$) der nichtlinearen Vorrichtung (102) repräsentieren;
Anwenden einer Modellparameter-Schätzprozedur unter Verwendung der empfangenen Daten, um Modellparameter ($\Phi$) eines Modells (208) zu erzeugen, das die Eingabe-Ausgabe-Eigenschaften der nichtlinearen Vorrichtung (102) charakterisiert;

Empfangen eines Eingabesignals ($w_t$), das ein gewünschtes Ausgabesignal der nichtlinearen Vorrichtung (102) repräsentiert;

Erzeugen eines vorverzerrten Eingabesignals ($x_t$) indem, für jeden einer Reihe aufeinanderfolgender Probeschätzwerte des vorverzerrten Eingabesignals ($x^{(k)}$), eine iterative Prozedur angewendet wird, um das vorverzerrte Eingabesignal ($x_t$) auf einen Wert zu setzen, der eine vorhergesagte Modellausgabe ($\hat{y}_t$) ergibt, die am besten mit der gewünschten Ausgabe ($w_t$) übereinstimmt, basierend auf den Modellparametern ($\Phi$), den früheren vorverzerrten Eingaben ($x_{t-T} \ldots x_{t-1}$), und den entsprechenden früheren nichtlinearen vorhergesagten Modellausgaben ($\hat{y}_{t-T} \ldots \hat{y}_{t-1}$); und

Bereitstellen des vorverzerrten Eingabesignals ($x_t$) zum Anlegen an den Eingang der nichtlinearen Vorrichtung (102), um zu bewirken, dass die nichtlineare Vorrichtung (102) einen Wert ($y_t$) ausgibt, der mit dem Signal ($w_t$), das das gewünschte Ausgabesignal repräsentiert, genau übereinstimmt.

2. Verfahren nach Anspruch 1, wobei die nichtlineare Vorrichtung (102) einen Leistungsverstärker umfasst.

3. Verfahren nach Anspruch 1, wobei das Anwenden der Modellparameter-Schätzprozedur Anwenden eines Ansatzes mit spärlicher Regression (sparse regression approach) umfasst, einschließlich Auswählen einer Teilmenge verfügbarer Modellparameter zur Charakterisierung von Eingabe-Ausgabe-Eigenschaften des Modells.

4. Verfahren nach Anspruch 1, wobei das Anwenden der iterativen Prozedur Anwenden einer numerischen Prozedur zur Lösung einer Polynomgleichung umfasst.

5. Verfahren nach Anspruch 1, wobei das Anwenden der iterativen Prozedur Anwenden einer Glaubensausbreitungs-Prozedur umfasst.

6. Verfahren nach Anspruch 1, wobei das Anwenden der iterativen Prozedur zum Erzeugen der Probe des modifizierten Eingabesignals Bestimmen einer Größe der Probe und einer Phase der Probe umfasst.

7. Verfahren nach Anspruch 1, wobei das Modell, das die Eingabe-Ausgabe-Eigenschaften der nichtlinearen Vorrichtung charakterisiert, ein Speicherpolynom oder ein Volterra-Reihen-Modell umfasst.

8. Verfahren nach Anspruch 1, ferner umfassend Interpolieren, um fehlende frühere Ausgaben zu finden, und Verwenden der interpolierten früheren Ausgaben in der Modellparameter-Schätzprozedur.

9. Verfahren nach Anspruch 1, wobei das Modell, das die Eingabe-Ausgabe-Eigenschaften der nichtlinearen Vorrichtung (102) charakterisiert, ein Modell umfasst, das eine Ausgabe der auf der nichtlinearen (102) Vorrichtung basierenden Daten vorhersagt, die einen Satz früherer Eingaben und einen Satz früherer Ausgaben der Vorrichtung repräsentieren.

10. Verfahren nach Anspruch 9, wobei das Modell, das die Eingabe-Ausgabe-Eigenschaften der nichtlinearen Vorrichtung (102) charakterisiert, ein unendliche-Impulsantwort- (IIR) Modell umfasst.

11. Verfahren nach einem der vorhergehenden Ansprüche, wobei die früheren Ausgaben ($y_{t-T} \ldots y_{t-1}$) der nichtlinearen Vorrichtung (102) durch unregelmäßiges Heruntertakten mit einem variablen Heruntertaktungsfaktor erzeugt werden.

12. System zum Linearisieren einer nichtlinearen Vorrichtung (102), wobei das System umfasst:

einen Schätzer (206), der konfiguriert ist, Daten zu empfangen, die frühere Proben vorverzerrter Eingaben ($x_{t-T} \ldots x_{t-1}$) der nichtlinearen Vorrichtung (102) und entsprechende frühere Ausgaben ($y_{t-T} \ldots y_{t-1}$) der nichtlinearen Vorrichtung (102) repräsentieren, und eine Modellparameter-Schätzprozedur anzuwenden, um Modellparameter ($\Phi$) eines Modells (208), das die Eingabe-Ausgabe-Eigenschaften der nichtlinearen Vorrichtung (102) charakterisiert, zu erzeugen , und wobei der Schätzer (206) konfiguriert ist, die Daten, die die früheren Proben vorverzerrter Eingaben ($x_{t-T} \ldots x_{t-1}$) der nichtlinearen Vorrichtung (102) und entsprechender früherer Ausgaben ($y_{t-T} \ldots y_{t-1}$) der nichtlinearen Vorrichtung (102) repräsentieren, in der Modellparameter-Schätzprozedur zu verwenden, um die Modellparameter (T) zu erzeugen; und
einen Vorverzerrer (204), aufweisend:

einen Eingang, der konfiguriert ist, ein Eingabesignal ($w_t$) zu empfangen, das ein gewünschtes Ausgabesignal der nichtlinearen Vorrichtung (102) repräsentiert,

einen Eingang, der konfiguriert ist, die Modellparameter ($\Phi$) von dem Schätzer (206) zu empfangen,

einen Eingang, der konfiguriert ist, die vorhergesagten Ausgaben ($y_{t-T}$ ... $\hat{y}_{t-1}$) von dem Modell (208) zu empfangen,

eine Verarbeitungsvorrichtung, die konfiguriert ist, ein vorverzerrtes Eingabesignal ($x_t$) zu erzeugen, indem, für jeden einer Reihe aufeinanderfolgender Probeschätzwerte des vorverzerrten Eingabesignals ($x^{(k)}$), eine iterative Prozedur angewendet wird, um das vorverzerrte Eingabesignal ($x_t$) auf einen Wert zu setzen, der eine vorhergesagte Modellausgabe ($y_t$) ergibt, die am besten mit der gewünschten Ausgabe ($w_t$) übereinstimmt, basierend auf den Modellparametern ($\Phi$), den früheren vorverzerrten Eingaben ($x_{t-T}$ ... $x_{t-1}$), und den entsprechenden früheren nichtlinearen vorhergesagten Modellausgaben ($\hat{y}_{t-T}$ ... $\hat{y}_{t-1}$), und

einen Ausgang zum Bereitstellen des vorverzerrten Eingabesignals ($x_t$) zum Anlegen an den Eingang der nichtlinearen Vorrichtung, um eine Ausgabe der nichtlinearen Vorrichtung (102) zu linearisieren, um zu bewirken, dass die nichtlineare Vorrichtung (102) einen Wert ($y_t$) ausgibt, der mit dem Signal ($w_t$), das das gewünschte Ausgabesignal repräsentiert, genau übereinstimmt.

13. System nach Anspruch 12, wobei der Schätzer (206) konfiguriert ist, einen Ansatz für eine spärliche Regression (sparse regression approach) anzuwenden, der Auswählen einer Teilmenge verfügbarer Modellparameter zur Charakterisierung von Eingabe-Ausgabe-Eigenschaften des Modells (208) aufweist.

14. System nach Anspruch 12, wobei die Verarbeitungsvorrichtung konfiguriert ist, eine numerische Prozedur anzuwenden, um eine Polynomgleichung oder eine Glaubensausbreitungs-Prozedur zu lösen.

15. System nach Anspruch 12, wobei das Modell, das die Eingabe-Ausgabe-Eigenschaften der nichtlinearen Vorrichtung charakterisiert, ein Modell umfasst, das eine Ausgabe der nichtlinearen Vorrichtung basierend auf Daten vorhersagt, die einen Satz früherer Eingaben und einen Satz früherer Ausgaben der Vorrichtung repräsentieren.

16. System nach einem der Ansprüche 12 bis 15, wobei die früheren Ausgaben ($y_{t-T}$ ... $y_{t-1}$) der nichtlinearen Vorrichtung (102) durch unregelmäßiges Heruntertakten mit einem variablen Heruntertaktungsfaktor erzeugt werden.

17. Nichtflüchtiges computerlesbares Medium, umfassend Anweisungen zum Bewirken, dass ein Datenprozessor Verfahrensschritte durchführt, die in einem der Ansprüche 1 bis 11 definiert sind.

**Revendications**

1. Procédé de linéarisation d'un dispositif non linéaire (102), comprenant les étapes suivantes :

   - réception des données qui représentent des entrées prédistordues passées ($x_{t-T}$...$x_{t-1}$) du dispositif non linaire (102) et des sorties passées correspondantes ($y_{t-T}$...$y_{t-1}$) du dispositif non linéaire (102) ;
   - application d'une procédure d'estimation de paramètres de modèle en utilisant les données reçues afin de générer des paramètres de modèle ($\Phi$) d'un modèle (208) qui caractérise des caractéristiques d'entrée-sortie du dispositif non linéaire (102) ;
   - réception d'un signal d'entrée ($w_t$) qui représente un signal de sortie souhaité du dispositif non linéaire (102) ;
   - génération d'un signal d'entrée prédistordu ($x_t$), pour chacune d'une série d'estimations d'échantillons successifs de signal d'entrée prédistordu ($x^{(k)}$), en appliquant une procédure itérative afin de régler le signal d'entrée prédistordu ($x_t$) à une valeur qui donne une sortie de modèle prédite ($\hat{y}_t$) qui coïncide le mieux avec la sortie souhaitée ($w_t$), sur la base des paramètres de modèle ($\Phi$), desdites entrées prédistordues passées ($x_{t-T}$...$x_{t-1}$) et de sorties de modèle prédites non linéaires passées correspondantes ($\hat{y}_{t-T}$...$\hat{y}_{t-1}$) ; et
   - génération du signal d'entrée prédistordu ($x_t$) pour l'appliquer à l'entrée du dispositif non linéaire (102), afin d'amener le dispositif non linéaire (102) à générer une valeur ($y_t$) qui coïncide étroitement avec le signal ($w_t$) qui représente le signal de sortie souhaité.

2. Procédé selon la revendication 1, dans lequel le dispositif non linéaire (102) comprend un amplificateur de puissance.

3. Procédé selon la revendication 1, dans lequel l'application de la procédure d'estimation de paramètres de modèle comprend l'application d'une approche de régression incomplète, comprenant la sélection d'un sous-ensemble de de paramètres de modèle disponibles pour caractériser des caractéristiques d'entrée-sortie du modèle.

4. Procédé selon la revendication 1, dans lequel l'application de la procédure itérative comprend l'application d'une procédure numérique pour résoudre une équation polynomiale.

5. Procédé selon la revendication 1, dans lequel l'application de la procédure itérative comprend l'application d'une procédure de propagation de croyance.

6. Procédé selon la revendication 1, dans lequel l'application de la procédure itérative pour générer l'échantillon du signal d'entrée modifié comprend la détermination d'une grandeur de l'échantillon et d'une phase de l'échantillon.

7. Procédé selon la revendication 1, dans lequel le modèle qui caractérise des caractéristiques d'entrée-sortie du dispositif non linéaire (102) comprend un polynôme de mémoire ou un modèle de la série Volterra.

8. Procédé selon la revendication 1, comprenant en outre une interpolation pour trouver des sorties passées manquantes et l'utilisation des sorties passées interpolées dans la procédure d'estimation de paramètres de modèle.

9. Procédé selon la revendication 1, dans lequel le modèle qui caractérise des caractéristiques d'entrée-sortie du dispositif non linéaire (102) comprend un modèle qui prédit une sortie du dispositif non linéaire (102) sur la base de données qui représentent un ensemble d'entrées passées et un ensemble de sorties passées du dispositif.

10. Procédé selon la revendication 9, dans lequel le modèle qui caractérise des caractéristiques d'entrée-sortie du dispositif non linéaire (102) comprend un modèle de Réponse Impulsionnelle Infinie (IIR).

11. Procédé selon l'une quelconque des revendications précédentes, dans lequel les sorties passées ($y_{t-T}...y_{t-1}$) du dispositif non linéaire (102) sont générées par un sous-échantillonnage irrégulier à un facteur de sous-échantillonnage variable.

12. Système de linéarisation d'un dispositif non linéaire (102), le système comprenant :

- un estimateur (206) configuré de manière à recevoir des données qui représentent des échantillons passés d'entrées prédistordues ($x_{t-T}...x_{t-1}$) du dispositif non linaire (102) et de sorties passées correspondantes ($y_{t-T}...y_{t-1}$) du dispositif non linéaire (102) et à appliquer une procédure d'estimation de paramètres de modèle afin de générer des paramètres de modèle ($\Phi$) d'un modèle (208) qui caractérise des caractéristiques d'entrée-sortie du dispositif non linéaire (102), et l'estimateur (206) est configuré de manière à utiliser les données qui représentent les échantillons passés d'entrées prédistordues ($x_{t-T}...x_{t-1}$) du dispositif non linaire (102) et de sorties passées correspondantes ($y_{t-T}...y_{t-1}$) du dispositif non linéaire (102) dans la procédure d'estimation de paramètres de modèle afin de générer les paramètres de modèle ($\Phi$) ; et
- un dispositif de prédistorsion (204), comprenant :

    • une entrée configurée de manière à recevoir un signal d'entrée ($w_t$) qui représente un signal de sortie souhaité du dispositif non linéaire (102) ;
    • une entrée configurée de manière à recevoir les paramètres de modèle ($\Phi$) en provenance de l'estimateur (206),
    • une entrée configurée de manière à recevoir les sorties prédites ($\hat{y}_{t-T}...\hat{y}_{t-1}$) en provenance du modèle (208),
    • un dispositif de traitement configuré de manière à générer un signal d'entrée prédistordu ($x_t$), pour chacune d'une série d'estimations d'échantillons successifs de signaux d'entrée prédistordus, en appliquant une procédure itérative afin de régler le signal d'entrée prédistordu ($x_t$) à une valeur qui donne une sortie de modèle prédite ($\hat{y}_t$) qui coïncide le mieux avec la sortie souhaitée ($w_t$), sur la base des paramètres de modèle ($\Phi$), desdites entrées prédistordues passées ($x_{t-T}...x_{t-1}$) et de sorties de modèle prédites non linéaires passées correspondantes ($\hat{y}_{t-T}...\hat{y}_{t-1}$) ; et
    • une sortie pour générer le signal d'entrée prédistordu ($x_t$) pour l'appliquer à l'entrée du dispositif non linéaire dans le but de linéariser une sortie du dispositif non linéaire (102), afin d'amener le dispositif non linéaire (102) à générer une valeur ($y_t$) qui coïncide étroitement avec le signal ($w_t$) qui représente le signal de sortie souhaité.

13. Système selon la revendication 12, dans lequel l'estimateur (206) est configuré de manière à appliquer une approche de régression incomplète qui comprend la sélection d'un sous-ensemble de paramètres de modèle disponibles afin de caractériser des caractéristiques d'entrée-sortie du modèle (208).

**14.** Système selon la revendication 12, dans lequel le dispositif de traitement est configuré de manière à appliquer une procédure numérique pour résoudre une équation polynomiale ou une procédure de propagation de croyance.

**15.** Système selon la revendication 12, dans lequel le modèle qui caractérise des caractéristiques d'entrée-sortie du dispositif non linéaire comprend un modèle qui prédit une sortie du dispositif non linéaire sur la base de données qui représentent un ensemble d'entrées passées et un ensemble de sorties passées du dispositif.

**16.** Système selon l'une quelconque des revendications 12 à 15, dans lequel les sorties passées ($y_{t-T}...y_{t-1}$) du dispositif non linéaire (102) sont générées par un sous- échantillonnage irrégulier à un facteur de sous-échantillonnage variable.

**17.** Support lisible par ordinateur non transitoire contenant des instructions pour amener un processeur de données à exécuter des étapes de procédé définies dans l'une quelconque des revendications 1 à 11.

FIG. 1

Pre-Distorter (D)
Solve:

$$x_t \quad \text{s.t.} \quad w_t \approx \hat{y}_t = P_\Theta\left(x_{t-T},...,x_{t-1},x_t,\hat{y}_{t-T},...,\hat{y}_{t-1}\right)$$

204

$w_1...w_t$

$\hat{y}_1...\hat{y}_t$

102

P

$x_1...x_t$

$y_1...y_t$

Estimator

206

207

$\Phi$

208

$P_\Phi$

$x_1...x_t$

$\hat{y}_1...\hat{y}_t$

FIG. 2

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 61560889 A
- US 61703895 A
- EP 1998436 A
- US 20050242876 A
- US 2005195919 A
- EP 1983659 A
- US 2004247042 A
- WO 0108297 A
- US 2005212596 A

### Non-patent literature cited in the description

- **JIE PENG et al.** *Partial Correlation Estimation by Joint Sparse Regression Models*